(19) Europäisches Patentamt / European Patent Office / Office européen des brevets

(11) **EP 2 677 291 B1**

(12) **EUROPEAN PATENT SPECIFICATION**

(45) Date of publication and mention
of the grant of the patent:
**20.09.2017 Bulletin 2017/38**

(51) Int Cl.:
**G06F 3/041** *(2006.01)*        **G01L 1/14** *(2006.01)*
**G06F 3/044** *(2006.01)*

(21) Application number: **12172602.0**

(22) Date of filing: **19.06.2012**

(54) **Capacitive force sensor and fabrication method**

Kapazitiver Kraftsensor und Herstellungsverfahren

Capteur de force capacitif et procédé de fabrication

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(74) Representative: **Prinz & Partner mbB
Patent- und Rechtsanwälte
Postfach 31 04 20
80104 München (DE)**

(43) Date of publication of application:
**25.12.2013 Bulletin 2013/52**

(56) References cited:
**JP-A- 3 239 940        US-A1- 2004 227 736
US-A1- 2008 218 299        US-A1- 2009 140 410
US-A1- 2010 090 297**

(73) Proprietor: **Technische Universität München
80333 München (DE)**

(72) Inventor: **Mittendorfer, Philipp
82152 Planegg (DE)**

EP 2 677 291 B1

**Description**

Field of the Invention

The invention relates to a capacitive force sensor or touch sensor as it may be employed in robotics or for human-machine interfaces, and likewise relates to a method for fabricating such a sensor on a substrate, in particular on a semiconductor substrate.

Background and State of the Art

Capacitive touch sensors are used in a variety of consumer electronics devices ranging from computer displays and mobile phones to laptop trackpads. Capacitive sensors are also employed widely to detect and measure proximity, position, humidity, fluid level, or acceleration. Moreover, capacitive sensors have been found suitable for sensing in robotics applications and may one day serve as an artificial skin of humanoid robots. Design engineers select capacitive sensors for their versatility, reliability and robustness.

Various different sensor designs exist, but all these sensors are based on the measurement of changes in capacitance due to a variation of an object that is conductive or dielectric. United States patent application US 2010/0102830 A1, assigned to Microchip Technology Incorporated discloses a touch sensor with a conductive capacitor plate formed on a substrate and surrounded by dielectric non-deformable spacer elements, which in turn support a protective cover. A conductive plane is formed at the underside of the protective cover so as to face the conductive plate formed on the substrate, and may be separated from the conductive plate by a deformable spacer that serves as a dielectric. The conductive plate and conductive plane sandwiching the dielectric deformable spacer serve as a parallel-plate capacitor. The conductive plane may be connected to ground, whereas the conductive plate on the substrate may be connected to readout electronics such as a Capacitive Voltage Divider (CVD) or a Charge Time Measurement Unit (CTMU). A user pressing his finger against the protective cover will apply a downward pressure on the conductive plane, leading to a decrease in the distance between the conductive plane and the conductive plate and hence to a change in capacitance of the parallel-plate capacitor. The change in capacitance is indicative of the applied force. A similar detector design in which two conductive layers are separated by dielectric spacer elements is described in United States patent application US 2003/0234769 A1.

These detectors are versatile, simple to operate and reliable. However, manufacturing them poses several challenges. The detectors are formed in multiple layers, and combining the protective cover with the substrate via the spacer elements involves the use of adhesives, which is both time-consuming and error-prone. Once the layered structure has been formed, additional wiring steps are required to electrically connect the conductive plane of the protective cover to ground and to electrically connect the conductive plane to the readout electronics. All these steps can be sources of inaccuracies.

A method for fabricating a capacitive force sensor and a resulting sensor including the features of the preamble portions of claims 1 and 9, respectively, are known from US 2004/0227736 A1. An upper electrode of the sensor is indirectly secured to a substrate with a connecting material, such as a solder. Structured elements embedded in the connecting material provide a predetermined spacing between the upper electrode and a lower electrode mounted directly to the substrate. Further, additional electrodes may be formed on a mounting surface of the substrate to provide an electrical connection between the upper electrode and other components associated with the substrate.

In US 2009/0140410 A1 a capacitive force sensor is shown with a first conductive element on a substrate and a plurality of spacer elements which may be formed on the same substrate. A heated solder is provided on the spacer elements. A cap element comprising a second conductive element is placed on the spacer elements via the solder such that the second conductive element faces the first conductive element and is spaced apart from the first conductive element. When the solder is cooled the cap element is bonded to the substrate, and electrical continuity is achieved between the solder, first electrode portions and the spacer elements.

JP H03-239940 A shows a capacitive pressure sensor which is formed by pressing a semiconductor substrate and a glass substrate together. A spacer and a joining layer are arranged next to each other within the same overall layer of the sensor. The joining layer is arranged at the entire periphery of an electrode formed on the glass substrate to a height that is a little bit larger than the height of the spacer. The spacer contacts both substrates when pressed together and determines the interval between the electrodes of both substrates, thereby constituting a reference pressure chamber which is sealed with the joining layer.

US 2010/090297 A1 shows a capacitive pressure sensor comprising a SOI substrate having a diaphragm and a recessed cap covering the diaphragm and forming a reference cavity, wherein the cap is joined to the substrate through use of metal joint members used as spacers. From US 2008/0218299 A1 it is known to use capillary forces of solder bumps for self-aligning two parts in the field of micro-electro-mechanical systems (MEMS). What is needed is a reliable and versatile force sensor that can be manufactured more quickly, at low costs and with an enhanced degree of accuracy.

Overview of the Invention

These objectives are achieved by means of a method for fabricating a capacitive force sensor according to independent claim 1, and a capacitive force sensor according to independent claim 9, respectively. The dependent claims relate to preferred embodiments.

A method for fabricating a capacitive force sensor according to the present invention comprises the steps of providing a first conductive element on a substrate. A plurality of spacer elements and at least one electrically conductive pad element are further provided on said substrate, and a solder is provided on said at least one pad element. The solder is heated. The method further comprises the step of providing a cap element comprising a second conductive element, wherein said cap element is placed on said spacer elements. Said cap element is connected with said pad element via said solder such that said second conductive element faces said first conductive element and is spaced apart from said first conductive element, and said solder is allowed to solidify. On a lower surface side of said cap element a recessed portion facing said first conductive element is formed.

According to the invention, the capacitive sensor is formed by placing a cap element comprising the second conductive element over the substrate on which the first conductive element is formed, and joining these elements via the pad element(s) by means of soldering. The spacer elements formed on said substrate serve to adjust and define the distance between the first conductive element and the second conductive element during the soldering, and hence define the capacitor gap. The solder establishes a mechanical and electrical connection between said cap element and said conductive pad element.

The method according to the invention has several advantages over the prior art. The first conductive element, spacer elements and pad element can be formed on the substrate with standard semiconductor deposition and/or etching techniques, and the same is true for the cap element. The joining of the cap element with the substrate via the spacers and conductive pads merely requires the careful placing of the cap over the substrate, which can be done quickly and automatically with conventional pick&place or insertion machinery that is available in all or most conventional semiconductor fabrication lines. Since the invention relies exclusively on conventional semiconductor fabrication techniques and equipment, both production cost and production times can be significantly reduced. This allows mass fabricating the sensor at a fraction of the cost of conventional designs.

Moreover, all mechanical and electrical connections can be formed by soldering, and no adhesives are required. Since the sensor is free of adhesives, it is more resilient to high temperatures.

Soldering concurrently establishes the mechanical and electrical connections of the cap element to the substrate. No additional step is required for wiring the second conductive element, thereby further reducing production time and production costs.

Since only standard semiconductor techniques are employed, the sensor according to the present invention can be fully integrated in a printed circuit board. This is a particular advantage for applications in consumer electronics, such as computer pads, computer screens or mobile phones, or if several touch sensors shall be arranged in close spatial proximity.

In a preferred embodiment, a plurality of electrically conductive pad elements are formed on said substrate, and the method comprises the steps of providing a solder on each of said plurality of pad elements, and connecting said cap element with said plurality of pad elements and solders.

A plurality of electrically conductive pad elements, each of them provided with a solder, allow reliably connecting the cap element to the substrate.

By suitably choosing the positions of said spacer elements and/or said conductive pad elements relative to the position of the first conductive element on said substrate, the invention allows to center the cap element and the second conductive element over the first conductive element. In particular, choosing the positions and dimensions of the conductive pad elements appropriately will generate capillary forces between the cap element and the solder formed on each of said plurality of pad elements that allow the cap element to automatically center on the pad elements and the first conductive element along a horizontal direction of the substrate. This further simplifies and speeds up the manufacturing, and allows forming the capacitive force sensor with high precision, and hence with very well-defined electrical properties.

Said pad elements may be positioned concentrically with respect to said first conductive element and/or said cap element and/or said second conductive element. The capillary forces between the cap element and the solder provided on said pad elements then allow the cap element to automatically align with the first conductive element along a horizontal direction of the substrate. The spacer elements formed on the substrate provide a well-defined spacing in the vertical direction.

In a preferred embodiment, all pad elements have the same surface size.

In a preferred embodiment, said cap element is connected with said plurality of pad elements and solders such that each pad element and solder is only partially covered by said cap element. In other words, the pad elements and solder may project sideways from said cap element.

In this configuration, the solder will not only contact a lower surface side of the cap element. Rather, capillary forces will lead to a wetting of portions of the side surface of the cap element that may be recessed from the pad elements. Upon solidification of the solder, this will provide for a particularly strong mechanical and electrical connection between said cap element and said pad elements.

In a preferred embodiment, the method comprises the step of providing a cover layer on said first conductive element and/or on said second conductive element and/or on said spacer elements. The cover layer may comprise a dielectric layer.

The cover layer may serve to protect against mechanical contact and electrical shorts between the first conductive element and the second conductive element.

Preferably, said cover layer comprises a solder protection varnish.

In a preferred embodiment, the method further comprises a step of providing a force concentration pad on said cap element on a side opposite to said second conductive element.

Said force concentration pad may be integrated into said cap element.

Said force concentration pad may serve to concentrate distributed forces that may act on an upper side of said cap element towards said second conductive element. Preferably, said force concentration pad is centered on said second conductive element.

In a preferred embodiment, said force concentration pad comprises a plastic or resin material, such as VeroWhite.

In a preferred embodiment, the method further comprises a step of providing a skin layer element overlying said cap element on a side opposite to said second conductive element.

Said skin layer element may be part of a skin layer overlying a plurality of capacitive force sensors.

Said skin layer element may comprise said force concentration pad.

In a preferred embodiment, said skin layer element may further comprise a force distribution element.

Preferably, said force distribution element is provided peripherally along a boundary of said skin layer.

The invention also relates to a capacitive force sensor comprising a substrate and a first conductive element formed on said substrate. A plurality of spacer elements are likewise formed on said substrate, wherein a cap element is supported on said spacer elements and comprises a second conductive element that faces said first conductive element and is spaced apart from said first conductive element. The capacitive force sensor further comprises at least one connection element, said connection element comprising an electrically conductive pad element formed on said substrate and further comprises a solder layer formed on said pad element and connecting said pad element to said cap element. A lower surface side of said cap element comprises a recessed portion facing said first conductive element.

In a preferred embodiment, the sensor comprises a plurality of connection elements, wherein each said connection element comprises an electrically conductive pad element formed on said substrate and further comprises a solder layer formed on said pad element and connecting said pad element to said cap element.

Preferably, said connection elements are positioned concentrically with respect to said first conductive element and/or said cap element and/or said second conductive element.

In the sense of the present invention, the connection elements may be understood to be positioned concentrically with respect to said first conductive element if the connection elements form a pattern on said substrate such that their center of mass overlaps with said first conductive element, and in particular coincides or approximately coincides with a center of mass of said first conductive element.

In a preferred embodiment, said spacer elements are spaced apart from said first conductive element and/or said connection element.

In a further preferred embodiment, said connection element is spaced apart from said spacer elements and/or said first conductive element.

This configuration allows the spacer elements and/or part of a surface of the substrate to electrically insulate said connection elements from said first conductive element.

In a preferred embodiment, said first conductive element and/or said second conductive element comprises a metal, in particular copper.

In particular, the entire cap element may be formed of a metal and may serve as the second conductive element.

In a preferred embodiment, the cap element comprises beryllium-copper. Beryllium-copper has the advantage of being firm and resilient, with a deflection or deformation that scales linearly with the applied force according to Hooke's Law. In addition, beryllium-copper can be directly and easily connected to copper circuit tracks on a printed circuit board by means of conventional solders. Beryllium-copper can be etched by standard lithography techniques, and hence the cap element can be mass-produced quickly and with high accuracy in the desired dimensions.

In a preferred embodiment, a cover layer is formed on said first conductive element and/or on said second conductive element and/or on said spacer elements. Preferably, said cover layer is a dielectric layer and comprises a solder protection varnish.

In a preferred embodiment, said first conductive element and/or said second conductive element is circular.

Preferably, said recessed portion is a circular recessed portion.

The distance between the first conductive element and the second conductive element, and hence the electrical properties of the capacitor, may be adjusted by selecting the depth of said recessed portion.

In a preferred embodiment, a lower surface side of said cap element comprises a connecting portion for connection with said connection element.

Said connecting portion may be elevated with respect to said recessed portion and may at least partially surround said recessed portion, wherein said spacer elements may support said connecting portion and/or said connection element may be connected to said connecting portion.

In a preferred embodiment, said connecting portion is a ring portion surrounding said recessed portion.

According to a preferred embodiment, said substrate is a printed circuit board.

Said substrate may comprise a dielectric material, in particular FR4.

The sensor may further comprise first connection means for connecting said first conductive element to a readout means. Said readout means may serve for deriving the value of a (change of) capacitance between said first conductive element and said second conductive element. Said readout means may involve conventional readout units, such as Capacitive Voltage Dividers (CVD) or Charge Time Measurements Units (CTMU).

A median filter may be provided as a pre-filter between said conductive element and said readout means.

The median filter may serve to avoid false low frequency aliasing signals and reduce jitter that may be due to noise.

In a preferred embodiment the median filter is provided as pre-filter which avoids undesired delay of common touch signals. A digital pre-filter serves to avoid low frequent aliasing and increases the signal-to-noise ratio.

In a preferred embodiment oversampling is used to shift filtering into the digital domain and spread noise.

The capacitive force sensor may further comprise second connection means for connecting said second conductive element to a predefined voltage, in particular to a ground voltage.

Providing the second conductive element at ground voltage allows avoiding an undesired build-up or accumulation of charges on the cap element, which might interfere with the capacitive force measurement.

The inventors found that the sensor according to the present invention does not necessarily require a dielectric medium (other than air) in the capacitor gap between the first conductive element and the second conductive element. Forming the capacitor without a dielectric medium further simplifies the processing, and hence contributes to reduce the manufacturing time and costs.

However, in an alternative configuration the sensor may further comprise a dielectric medium placed in a gap between said first conductive element and said second conductive element. A dielectric medium may be desirable if the applications demand a particularly high capacitance.

In a preferred embodiment the dielectric is a liquid that is held by capillary effects in between said first conductive element and said second conductive element and can relieve through said wire channel.

In a preferred embodiment, the sensor comprises a force concentration pad placed on said cap element on a side opposite said second conductive element.

Preferably, said force concentration pad is centered on said second conductive element.

In a preferred embodiment, the sensor further comprises a force distribution element on said cap element.

Preferably, said force distribution element is provided peripherally along a boundary of said cap element.

In a preferred embodiment, a skin layer element incorporating said force concentration pad and/or said force distribution element overlies said cap element.

Detailed Description of Preferred Embodiments

The features and numerous advantages of the capacitive force sensor and fabrication method according to the present invention will be best understood from a detailed description of the preferred embodiments with reference to the appended drawings, in which:

Fig. 1        is a cross-sectional view of a capacitive force sensor according to an embodiment of the present invention;

Fig. 2        is a top view of a substrate provided with a capacitor plate, a plurality of spacer elements and a plurality of pad elements according to an embodiment of the invention;

Figs. 3a, 3b   are a schematic top view and perspective view, respectively, of a cap element according to an embodiment of the present invention;

Fig. 4a       is a photograph of a substrate provided with a capacitor plate, a plurality of spacer elements and a plurality of solder pads according to an embodiment of the present invention;

Fig. 4b       is a photograph of a cap element designed to fit over the capacitor plate and spacers shown in Fig. 4a;

Fig. 5        is a photograph of a sensor cell with three capacitive force sensors according to an embodiment of the invention;

Fig. 6        is a diagram showing a readout signal of a capacitive force sensor according to Fig. 5;

Figs. 7a, 7b   are a front view and a back view, respectively, of a skin layer element with force concentration pads and a force distribution layer according to an embodiment of the present invention; and

Figs. 8a, 8b     are diagrams showing a response signal when a force is applied to a capacitive force sensor provided with an overlying skin layer element as shown in Figs. 7a, 7b.

The invention will now be described for the specific example of a touch sensor that may be employed in a switch in a consumer electronics device and may be actuated in response to a user pressing her finger on the cap element. However, the invention is not limited to touch sensors, and may also be employed to detect other forces, such as forces resulting from an impact, an acceleration, or the change of a fluid level.

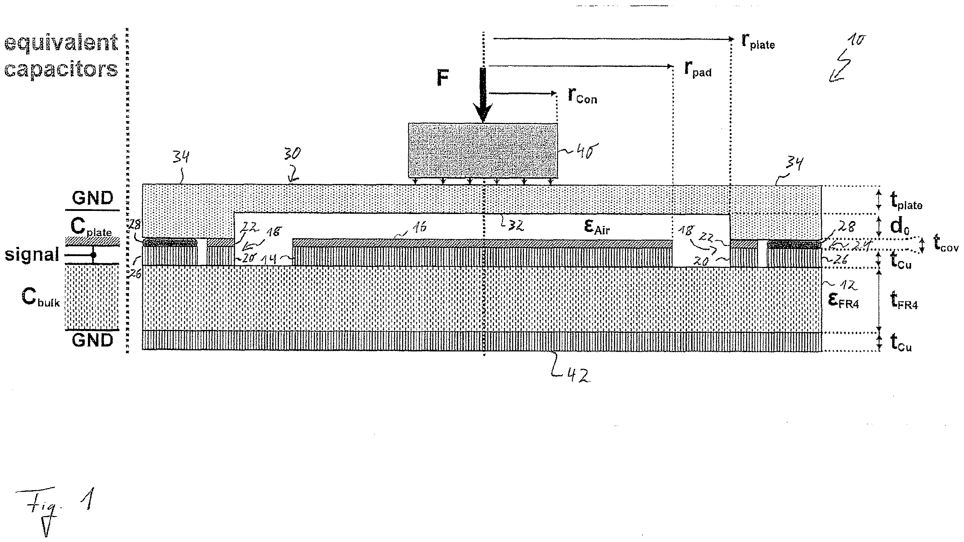

Fig. 1 is a cross-sectional view of a touch sensor 10 that comprises a substrate 12 and a circular capacitor plate 14 formed on the substrate 12. The substrate 12 may be a dielectric substrate and may be made from FR4, and may form part of a printed circuit board.

The capacitor plate 14 may be formed of copper or any other suitable metal. A dielectric or insulating cover layer 16 may be formed on the capacitor plate 14. For instance, said cover layer 16 may comprise a solder protection varnish or solder stop layer.

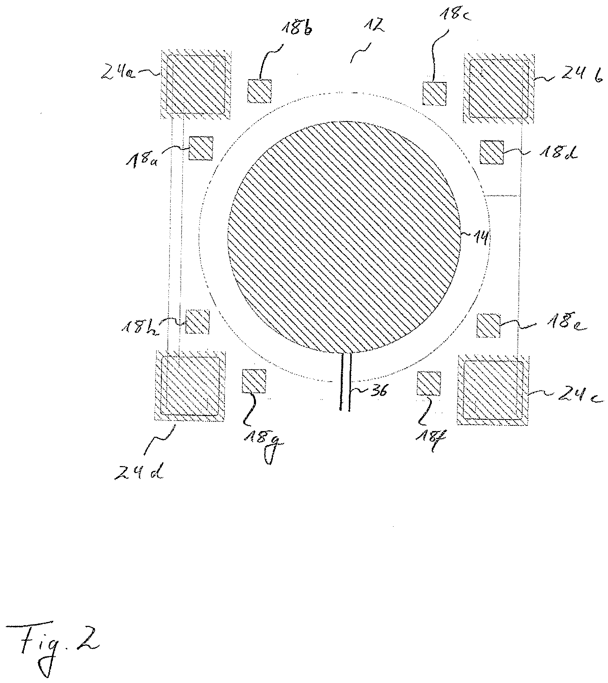

As can be further taken from Fig. 1, spacer elements 18 are provided on said substrate 12 so as to surround the capacitor plate 14, but to be spatially separated therefrom. The top view of Fig. 2 shows eight square-shaped spacer elements 18a to 18h that surround the circular capacitor plate 14. The spacer elements 18, 18a to 18h each comprise a lower portion 20 formed on an upper surface of said substrate 12 and made out of copper, and a cover portion 22 formed of the solder protection varnish or some other dielectric material and placed on said lower portion 20.

Connection elements 24 are further provided on the substrate 12 and are spatially separated both from said spacer elements 18 and from said capacitor plate 14. As can be taken from the top view of Fig. 2, four square-shaped connection elements 24a to 24d are arranged to surround the circular capacitor plate 14 and spacer elements 18a to 18h, with each of the connection elements 24a, 24b, 24c, 24d being formed in close spatial proximity to two respective spacer elements 18a, 18b; 18c, 18d; 18e, 18f; 18g, 18h. Each of the connection elements 24, 24a to 24d comprises an electrically conductive pad element 26 formed on the substrate 12 as well as a solder layer 28 formed on said conductive pad element 26. The conductive pad element 26 may be formed of copper or any other suitable metal, whereas the solder layer 28 may be formed by providing any conventional solder agent on the conductive pad element 26, such as SnPb.

The touch sensor 10 further comprises a cap element 30 with a central circular recessed portion 32 and a ring-shaped connecting portion 34 surrounding said recessed portion 32 and being elevated with respect to said recessed portion 32. The connecting portion 34 rests on the spacer elements 18 and is electrically and mechanically connected to the substrate 12 via the solder layer 28 and conductive pad elements 26. The recessed portion 32 faces the capacitor plate 14 and cover layer 16, but is spatially separated therefrom such that a gap of width $d_0$ is formed between a lower surface side of the recessed portion 32 and an upper surface side of the cover layer 16. The cap element 30 hence serves as the counter-electrode to the capacitor plate 14. It may be formed of a bendable, resilient metal, such as $CuBe_2$.

Connection means (not shown) may be provided to connect the cap element 30 to ground via the connecting portion 34, solder layer 28, and conductive pad element 26.

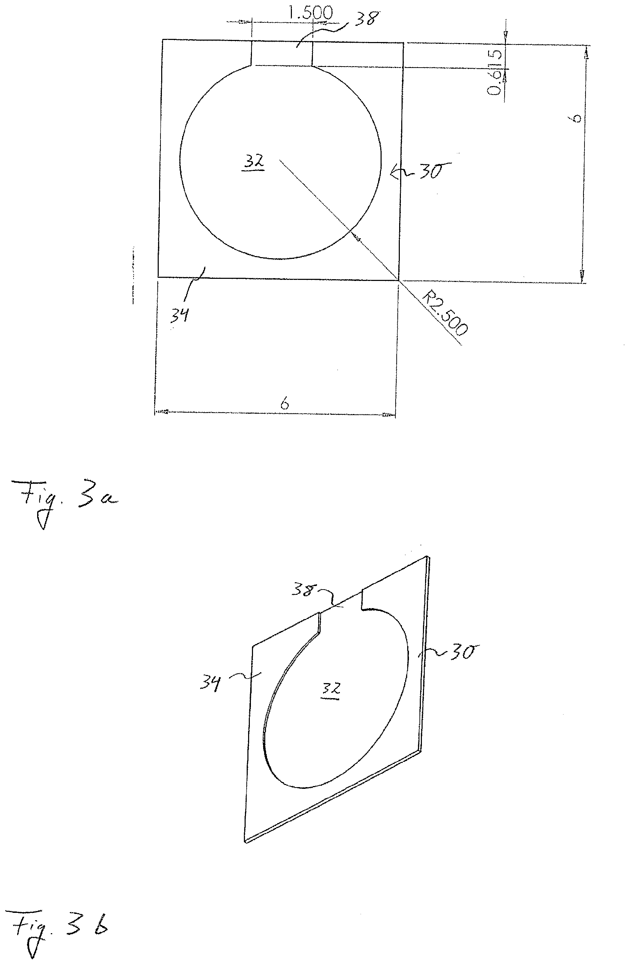

As shown in the top view of Fig. 2, further connection means 36, such as a printed copper wire may be provided to connect the capacitor plate 14 to a readout means (not shown). As can be taken from Figures 3a and 3b, the connecting portion 34 of the cap element 30 comprises an opening 38 that connects with the recessed portion 32. The opening 38 serves as a wire channel and provides space for the signal wire 36 that connects the capacitor plate 14 to the readout means. The readout means may be adapted to read out a voltage and/or charge pertaining to the capacitor plate 14, and to detect a change in capacitance that may occur when the distance do between the capacitor plate 14 and the cap element 30 changes due to a force F acting on an upper side of the cap element 30. Different methods of measuring capacitance are known in the art and can be used in the readout means according to the present invention. The readout means may comprise Capacitive Sensing Modules (CSM), Capacitive Voltage Dividers (CVD) or Charge Time Measurement Units (CTMU), or any other suitable readout electronics. These readout techniques are well-known to those skilled in the art, and hence a detailed description will be omitted.

One functionality a CTMU provides is a programmable and switchable constant current source. The CTMU strongly links to other peripherals like the timer and the analog-to-digital converter (ADC). The CTMU allows generating a constant current *I* and allows the timer to accurately gate the time *T* and the ADC to measure the final voltage value *U*. The CTMU current source can be multiplexed to any of the analog input pins of the micro controller. Amongst other functionalities, this allows to measure the capacitance of capacitors attached to any of the analog input pins. Provided the capacitor was initially discharged, the capacitance can directly be calculated by:

$$C = \frac{Q}{U} = \frac{I \cdot T}{U}$$

One may set the constant current to the maximum of $I_{max} = 55\mu A$, which allows the highest update rates and gives resistive parasitic effects least time to interfere. The maximum voltage is limited by the supply voltage and the ADC range, here the maximum may be set to $U_{max} = 3.0V$. The maximum voltage $U_{max}$ is applied in case of an unloaded sensor cell. The capacitance increases once the capacitor plates are forced together. Keeping the charge Q constant, the voltage U decreases. This gives way to an automatic range optimization, matching the range of the ADC and the unloaded voltage output, incrementing or decrementing the default timer setting to a custom value $T_{custom}$ for each force sensor. One may utilize the heuristic default time $T_{default} = 40*62.5ns = 2.5\mu s$ for both charging and discharging times. The initial capacitance of the force sensor and all parasitic capacitors like the pin or ADC sample and hold capacitor sum up to a minimal initial value of $C_{init} = 46pF$.

With a sample rate of $R_{12bit} = 200k \dfrac{samples}{s}$ at 12 bit resolution, one analog-to-digital conversion approximately takes $T_{ADC} \approx 5\mu s$. A complete force measurement then approximately takes $T_{force} \approx T_{ADC} + 2 \cdot T_{default} \approx 10\mu s$. A unit cell could hence theoretically sample all three force cells of a unit with an update rate of $f_{max} = 33kHz$. One may use a sample rate of $f_{samp} = 2.5kHz$ and decimate to the lower transmission rate $f_{out} = 250Hz$ after applying a digital filter.

The digital filter in combination with the oversampling rate serves two purposes: (i) a digital filter to obey the Nyquist sampling theorem is much easier to realize; (ii) oversampling allows filtering uncorrelated noise, and this increases the signal-to-noise ratio. Filtering in control systems is generally avoided due to the inherent phase shifts. It is nonetheless advantageous to avoid false low frequency aliasing signals and to reduce jitter due to noise.

In an embodiment of the invention, one may utilize a non-linear median filter on the last $N = 10$ samples. Median filters do not degrade edges and effectively reduce noise. In our case with $N = 10$ and a following decimation by the same factor, the maximum phase shift for a step response is half the sample time.

A force concentration pad 40 may be placed on an upper surface side of the cap element 30, or may alternatively be structurally integrated into the cap element 30. When centered on the underlying capacitor plate 14, the force concentration pad 40 may serve to concentrate the external forces exerted upon the touch sensor 10 towards the capacitor plate 14, thereby enhancing the sensitivity of the sensor device. The force concentration pads 40 are particularly useful to detect forces stemming from hard objects over an extended surface area. They may not be required to detect soft objects, such as a user's fingertip. The force concentration pad 40 may be made of plastics material, such as Vero White.

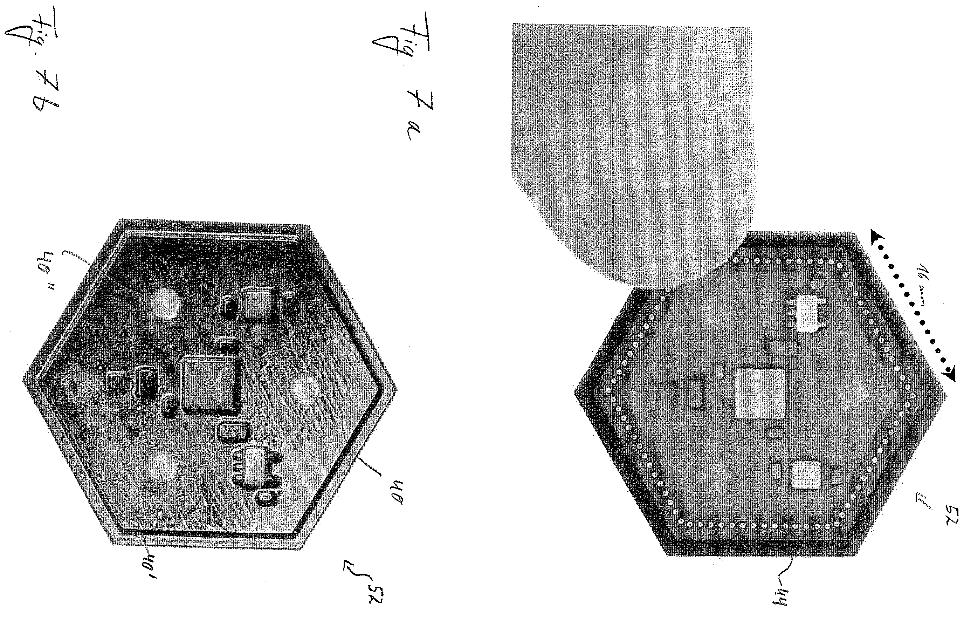

Alternatively, the force concentration pad may be integrated into a skin layer 52 overlying the touch sensor 10, possibly together with a force distribution element 44, as will be described further below with reference to Figs. 7a and 7b.

A metal shielding layer 42 may be provided on a lower surface side of the substrate 12 opposite the capacitor plate 14, and may be connected to ground to shield the sensor 10 against external electromagnetic signals that could interfere with the capacitor readings. The shielding layer 42 may be formed of copper.

Manufacturing of the touch sensor 10 will now be described with reference to Figs. 1 to 4. The substrate 12 is provided at the desired thickness $t_{FR4}$. Depending on the intended application, $t_{FR4}$ may be in the range of several micrometers to several millimeters, such as 50 to $200\mu m$.

Standard semiconductor fabrication techniques may be employed to form the capacitor plate 14, spacer elements 20 and conductive pad elements 26 on the upper surface of the substrate 12 at a desired thickness $t_{Cu}$, depending on the application. For instance, $t_{Cu}$ may amount to 40 $\mu m$ to 60 $\mu m$. The capacitor plate 14 may be provided at a radius $r_{pad}$ of a few millimeters, again depending on the application. For instance, $r_{pad}$ may amount to 2 mm. The wire connection 36 to the capacitor plate 14 and/or a wire connection connecting the conductive pad elements 26 to ground may be formed in the same fabrication step.

The dielectric cover layer 16 and the cover portion 22 are then provided on the capacitor plate 14 and lower portion 20 of the spacer elements 18, respectively. The thickness $t_{cov}$ of the cover layer 16 and cover portion 22 may amount to a few micrometers, such as 5 to 50 $\mu m$.

In a subsequent step, a solder paste is applied to the upper surface of the conductive pads 26, and is heated. This may form part of a standard soldering step in a semiconductor fabrication line.

The cap element 30 and in particular the recessed portion 32 thereof can be formed by means of wet etching, and the depth of the recessed portion 32 may be controlled by adjusting the etching parameters and time. For instance, the cap element 30 may be a square plate with dimensions 6 mm x 6 mm and with a circular recessed portion 32 with a radius $r_{plate} = 2.5$ mm. The thickness $t_{plate}$ of the cap element 30 may amount to 50 $\mu m$ in the recessed portion 32, and the depth $d_0$ of the recess may likewise amount to 50 $\mu m$. These dimensions may be chosen freely depending on the application.

Standard automatic insertion equipment as conventionally employed in semiconductor fabrication lines may be used to place the cap element 30 on the spacer elements 18 and on the heated solder 28 provided on the conductive pad elements 26. The spacer elements 18 serve to adjust the distance between the capacitor plate 14 and the cap element 30, and hence determine

the capacitor gap $d_0$ and the electrical properties of the force sensor 10. As shown in Fig. 2, the connection elements 24a, 24b, 24c and 24d are positioned concentrically around the capacitor plate 14, and are equal in surface size. Hence, the capillary forces between the solder 28 and the lower surface side of the connecting portion 34 of the cap element 30 will automatically align and center the cap element 30 onto the connection elements 24a - 24d, and will thereby align the recessed portion 32 of the cap element 30 with the capacitor plate 14.

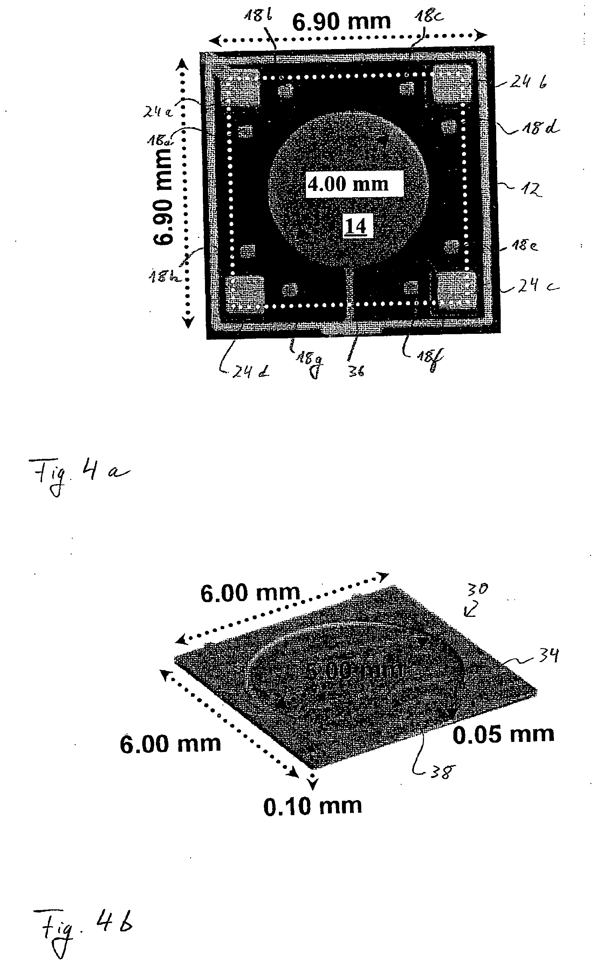

Figs. 4a and 4b are photographs of an exemplary substrate 12 and cap element 30, respectively, that were taken before the step of joining these two elements. The position that will be taken by the cap element 30 on the substrate 12 upon connection is indicated with dotted lines in Fig. 4a. The connection elements 24a to 24d are placed on the substrate 12 such that they slightly extend beyond the outer boundaries of the cap element 30. Capillary forces will then also act between the solder 28 and the side edges of the cap element 30, thereby pulling the cap element 30 against the connection elements 26 and spacer elements 18. Upon solidifying of the solder 28, a resilient and stable mechanical and electrical connection will then form between the cap element 30 and the conductive pad elements 26.

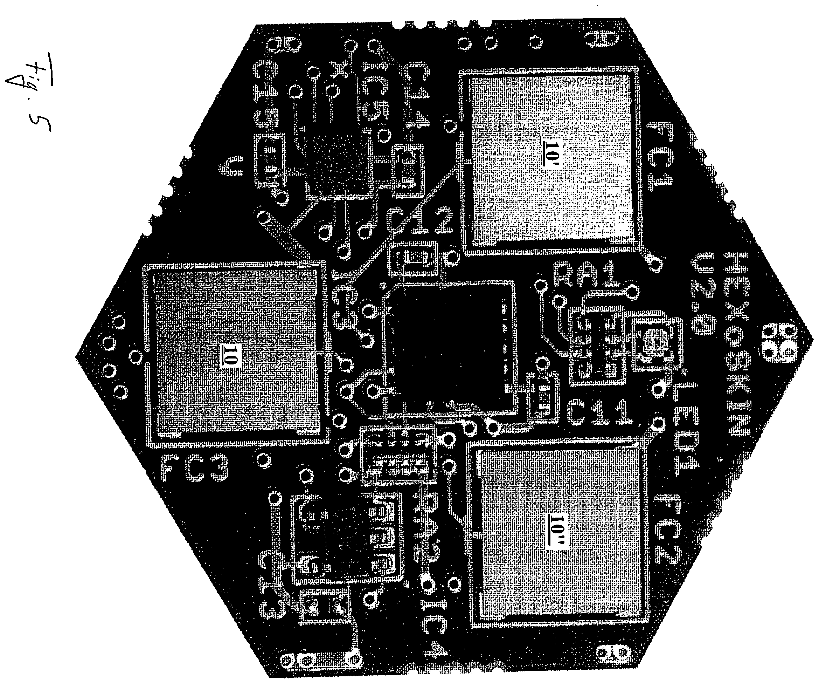

Several sensor cells may share a common substrate 12 and cap element 30. Fig. 5 is a photograph of a prototype of a sensor cell with three capacitive force sensors 10, 10', 10" formed on a common printed circuit board. Since the touch sensors 10, 10', 10" can be formed entirely by conventional semiconductor fabrication techniques, they are very well suited for integration into printed circuit boards, such as used in consumer electronics and robotics.

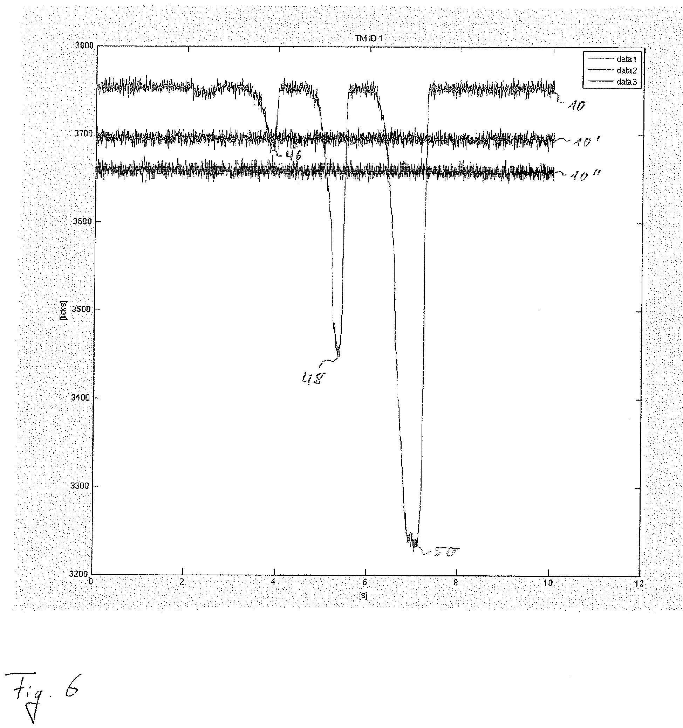

Fig. 6 represents the response signals of the touch sensors 10, 10', 10" of the sensor cell shown in Fig. 5. The small peak 46 corresponds to a small force, whereas the intermediate peak 48 and the large peak 50 correspond to an intermediate and large force, respectively, which are consecutively applied by a user's finger directly on the upper surface of the cap element 30 of sensor 10. No force is applied to the other two touch sensors 10' and 10", and hence their readout curves are essentially flat. As can be taken from Fig. 6, the touch sensor according to the present invention not only allows detecting a force being applied to an upper surface of the cap element 30 or force concentration pad 40, but also allows to reliably assess the magnitude of that force and distinguish between different forces.

A skin layer 52 may be provided to overlie the sensor cell shown in Fig. 5. Figs. 7a and 7b show the front side and back side of a hexagonal skin layer element, respectively. The back side overlies and faces an upper side of the cap element 30, and hence the touch sensors 10, 10', 10", whereas the front side opposes the back side and serves to receive and distribute forces applied by a user. The skin layer 52 may incorporate on its back side three force concentration pads 40, 40', 40" centered on the respective sensor elements 10, 10', 10".

As can be taken from Fig. 7a, a force distribution element 44 may be provided on the front side of the skin layer 52 to evenly distribute forces applied to the front side of the skin layer 52 over the three touch sensors 10, 10', 10". The force distribution element 44 may be provided circumferentially along a boundary of the hexagonal skin layer element 52. The force distribution element 44 may be formed of plastics, such as VeroWhite. However, any other hard material may likewise be employed. In particular, the force distribution element 44 may be a metal layer.

The skin element 52 may have a body made from a soft material such as rubber that encapsulates the force concentration pads 40, 40', 40" and the force distribution element 44. The skin layer element 52 may be printed in a very short time and with high accuracy (16μm resolution) by using an Objet Polyjet prototyping machine. Such skin layer 52 may serve as an artificial skin in robotics applications.

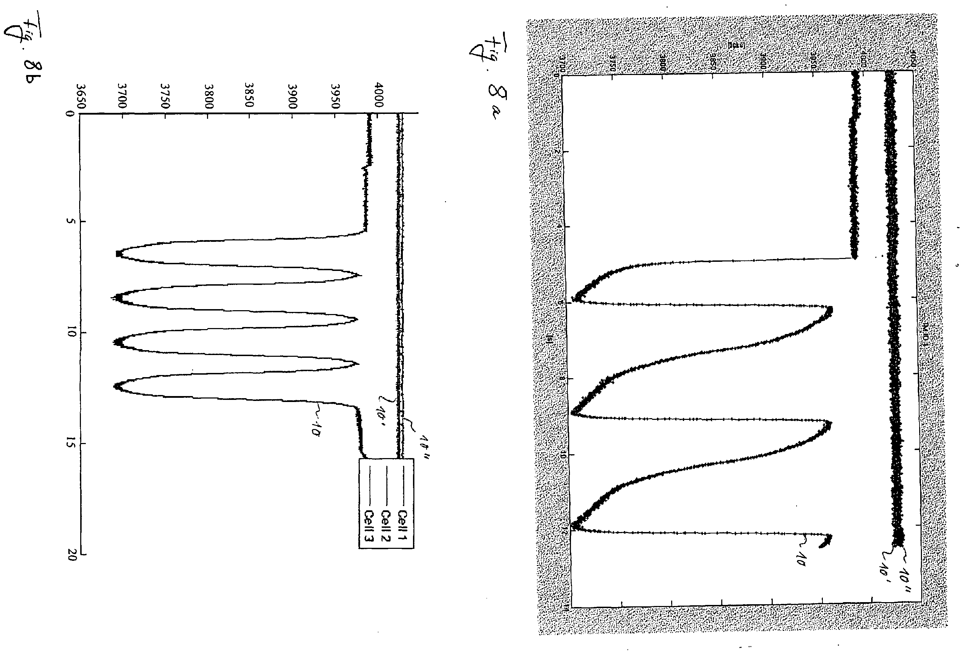

Fig. 8a shows a response signal of the touch sensors 10, 10', 10" of the sensor cell shown in Fig. 5, and is hence similar to Fig. 6. However, Fig. 6 shows the response when a user presses his finger directly on the upper surface of the cap element 30 of sensor 10, whereas Fig. 8a shows the response when a force is applied on the front side of the skin element 52 overlying the cap element 30. A linear voice coil motor that provides an approximately linear conversion between voltage and force was employed to generate a saw tooth signal and the force was centered on the first sensor cell 10. The rising slope of the saw tooth signal was set to be nine times slower than the falling slope. As can be taken from the response diagram of Fig. 8a, the sensor 10 provides a reproducible response signal that allows reliably distinguishing between small and large forces.

Fig. 8b shows a corresponding response signal of the sensor 10, but for a sinusoidal force applied to the front side of the skin element 52. Again, the sensor 10 provides a reproducible signal response that follows the sinusoidal driving force.

The description of the preferred embodiments and the Figures merely serve to illustrate the invention and the advantages over the prior art, but should not be understood to imply any limitation. The scope of the invention shall be determined solely by the appended claims.

List of reference signs

| | |
|---|---|
| 10, 10', 10" | touch sensor |
| 12 | substrate |
| 14 | capacitor plate |
| 16 | cover layer of capacitor plate 14 |
| 18, 18a - 18h | spacer elements |
| 20 | lower portion of spacer elements |

| | |
|---|---|
| 22 | cover portion of spacer elements |
| 24, 24a - 24d | connection elements |
| 26 | conductive pad element of connection element 24 |
| 28 | solder layer |
| 30 | cap element |
| 32 | recessed portion of cap element 30 |
| 34 | connecting portion of cap element 30 |
| 36 | connection means |
| 38 | opening of connecting portion 34 |
| 40, 40', 40" | force concentration pad |
| 42 | shielding layer |
| 44 | force distribution element |
| 46 | peak corresponding to small force |
| 48 | peak corresponding to intermediate force |
| 50 | peak corresponding to large force |
| 52 | skin layer element |

**Claims**

1. A method for fabricating a capacitive force sensor (10, 10', 10"), comprising:

   providing a first conductive element (14) on a substrate (12), wherein a plurality of spacer elements (18, 18a - 18h) and an electrically conductive pad element (26) are formed on said substrate (12);
   providing a heated solder (28) on said pad element (26);
   providing a cap element (30), said cap element (30) comprising a second conductive element;
   placing said cap element (30) on said spacer elements (18, 18a - 18h);
   connecting said cap element (30) with said pad element (26) via said solder (28) such that said second conductive element faces said first conductive element (14) and is spaced apart from said first conductive element (14); and
   allowing said solder (28) to solidify;
   **characterized in** forming on a lower surface side of said cap element (30) a recessed portion (32) facing said first conductive element (14).

2. The method according to claim 1, wherein a plurality of electrically conductive pad elements (26) are formed on said substrate (12), and the method comprises the steps of providing a solder (28) on each of said plurality of pad elements (26), and connecting said cap element (30) with said plurality of pad elements (26) via said solder (28).

3. The method according to claim 2, wherein said pad elements (26) are positioned concentrically with respect to said first conductive element (14) and/or said cap element (30) and/or said second conductive element.

4. The method according to claim 2 or 3, wherein said pad elements (26) are positioned relative to said first conductive element (14) on said substrate (12) so that said second conductive element aligns itself with said first conductive element (14) by means of capillary forces between said solder (28) and said cap element (30) when said cap element (30) is placed on said solder (28).

5. The method according to any of the claims 2 to 4, wherein said cap element (30) is connected with said plurality of pad elements (26) and solder (28) such that each pad element (26) and solder (28) is only partially covered by said cap element (30).

6. The method according to any of the preceding claims, comprising a step of providing a cover layer (16; 22) on said first conductive element (14) and/or on said second conductive element and/or on said spacer elements (18, 18a - 18h), wherein said cover layer (16; 22) preferably comprises a solder protection varnish.

7. The method according to any of the preceding claims, further providing a force concentration pad (40, 40', 40") on said cap element (30) on a side opposite said second conductive element, preferably centred on said second conductive element.

8. The method according to any of the preceding claims, further providing a skin layer (52) overlying said cap element (30), wherein said skin layer (52) preferably comprises a force concentration pad (40, 40', 40") and/or a force distribution element (44).

9. A capacitive force sensor (10, 10', 10"), comprising:

   a substrate (12);
   a first conductive element (14) formed on said substrate (12);
   a plurality of spacer elements (18, 18a - 18h) formed on said substrate (12);
   a cap element (30) supported on said spacer elements (18, 18a- 18h), said cap element (30) comprising a second conductive element that faces said first conductive element (14) and is spaced apart from said first conductive element (14); and
   at least one connection element (24, 24a - 24d), said connection element (24, 24a - 24d) comprising an electrically conductive pad element (26) formed on said substrate (12) and further comprising a solder layer (28) formed on said pad element (26) and connecting said pad element (26) to said cap element (30);
   **characterized in that** a lower surface side of said cap element (30) comprises a recessed portion (32) facing said first conductive element (14).

10. The sensor (10, 10', 10") according to claim 9, comprising a plurality of connection elements (24, 24a - 24d), wherein each said connection element (24, 24a - 24d) comprises an electrically conductive pad element (26) formed on said substrate (12) and further comprises a solder layer (28) formed on said pad element (26) and connecting said pad element (26) to said cap element (30).

11. The sensor (10, 10', 10") according to claim 10, wherein said connection elements (24, 24a-24d) are positioned concentrically with respect to said first conductive element (14) and/or said cap element (30) and/or said second conductive element.

12. The sensor (10, 10', 10") according to any of the claims 9 to 11, wherein said recessed portion (32) is circular.

13. The sensor (10, 10', 10") according to claim 12, wherein a lower surface side of said cap element (30) comprises a connecting portion (34), said connecting portion (34) being elevated with respect to said recessed portion (32) and at least partially surrounding said recessed portion (32), wherein said spacer elements (18, 18a - 18h) support said connecting portion (34) and/or said connection element (24, 24a - 24d) is connected to said connecting portion (34).

14. The sensor (10, 10', 10") according to any of the claims 9 to 13, further comprising a force concentration pad (40, 40', 40") formed on said cap element (30) on a side opposite said second conductive element, preferably centred on said second conductive element.

15. The sensor (10, 10', 10") according to any of the claims 9 to 14, further comprising a force distribution element (44) on said cap element (30), preferably peripherically along a boundary of said cap element (30).


**Patentansprüche**

1. Verfahren zum Herstellen eines kapazitiven Kraftsensors (10, 10', 10"), das umfasst:

   Vorsehen eines ersten leitfähigen Elements (14) auf einem Substrat (12), wobei eine Vielzahl von Abstandselementen (18, 18a - 18h) und ein elektrisch leitfähiges Pad-Element (26) auf dem Substrat (12) ausgebildet sind;

   Vorsehen eines erhitzten Lötmaterials (28) auf dem Pad-Element (26);
   Vorsehen eines Kappenelements (30), wobei das Kappenelement (30) ein zweites leitfähiges Element umfasst;
   Anordnen des Kappenelements (30) auf den Abstandselementen (18, 18a - 18h);
   Verbinden des Kappenelements (30) mit dem Pad-Element (26) über das Lötmaterial (28), sodass das zweite leitfähige Element dem ersten leitfähigen Element (14) zugewandt ist und von dem ersten leitfähigen Element (14) beabstandet ist; und
   Ermöglichen des Verfestigens des Lötmaterials (28);
   **dadurch gekennzeichnet, dass** auf einer unteren Oberflächenseite des Kappenelements (30) ein ausgesparter Abschnitt (32) ausgebildet wird, der dem ersten leitfähigen Element (14) zugewandt ist.

2. Verfahren nach Anspruch 1, wobei eine Vielzahl von elektrisch leitfähigen Pad-Elementen (26) auf dem Substrat (12) ausgebildet werden, und das Verfahren die Schritte des Vorsehens eines Lötmaterials (28) auf einem jeden der Vielzahl der Pad-Elemente (26) und das Verbinden des Kappenelements (30) mit der Vielzahl der Pad-Elemente (26) über das Lötmaterial (28) umfasst.

3. Verfahren nach Anspruch 2, wobei die Pad-Elemente (26) konzentrisch bezüglich des ersten leitfähigen Elements (14) und/oder des Kappenelements (30) und/oder des zweiten leitfähigen Elements angeordnet sind.

4. Verfahren nach Anspruch 2 oder 3, wobei die Pad-Elemente (26) bezüglich des ersten leitfähigen Elements (14) auf dem Substrat (12) angeordnet sind, sodass das zweite leitfähige Element sich an dem ersten leitfähigen Element (14) mit Hilfe von Kapillarkräften zwischen dem Lötmaterial (28) und dem Kappenelement (30) ausrichtet, wenn das Kappenelement (30) auf dem Lötmaterial (28) angeordnet wird.

5. Verfahren nach einem der Ansprüche 2 bis 4, wobei das Kappenelements (30) mit der Vielzahl von Pad-Elementen (26) und dem Lötmaterial (28) dergestalt verbunden ist, dass jedes Pad-Element (26) und Lötmaterial (28) nur teilweise von dem Kappenelement (30) bedeckt ist.

6. Verfahren nach einem der vorhergehenden Ansprüche, das einen Schritt des Vorsehens einer Abdeckungsschicht (16; 22) auf dem ersten leitfähigen Element (14) und/oder auf dem zweiten leitfähigen Element und/oder auf den Abstandselementen (18, 18a - 18h) umfasst, wobei die Abdeckungsschicht (16; 22) vorzugsweise einen Lötmaterial-Schutzlack umfasst.

7. Verfahren nach einem der vorhergehenden Ansprüche, das weiterhin ein Kraftkonzentrations-Pad (40, 40', 40") auf dem Kappenelement (30) an einer Seite gegenüber dem zweiten leitfähigen Element umfasst, vorzugsweise mittig auf dem zweiten leitfähigen Element angeordnet.

8. Verfahren nach einem der vorhergehenden Ansprüche, das weiterhin eine Außenschicht (52) vorsieht, die das Kappenelement (30) überzieht, wobei die Außenschicht (52) vorzugsweise ein Kraftkonzentrations-Pad (40, 40', 40") und/oder ein Kraftverteilungselement (44) umfasst.

9. Kapazitiver Kraftsensor (10, 10', 10"), der umfasst:

ein Substrat (12);
ein auf dem Substrat (12) ausgebildetes erstes leitfähiges Element (14);
eine Vielzahl von auf dem Substrat (12) ausgebildeten Abstandselementen (18, 18a - 18h);
ein auf den Abstandselementen (18, 18a - 18h) gehaltenes Kappenelement (30), wobei das Kappenelements (30) ein zweites leitfähiges Element umfasst, das dem ersten leitfähigen Element (14) zugewandt ist und von dem ersten leitfähigen Element (14) beabstandet ist; und wenigstens ein Verbindungselement (24, 24a - 24d), wobei das Verbindungselement (24, 24a - 24d) ein auf dem Substrat (12) ausgebildetes elektrisch leitfähiges Pad-Element (26) umfasst und weiterhin eine auf dem Pad-Element (26) ausgebildete Lötschicht (28) umfasst und das Pad-Element (26) mit dem Kappenelement (30) verbindet;
**dadurch gekennzeichnet, dass** auf einer unteren Oberflächenseite des Kappenelements (30) ein ausgesparter Abschnitt (32) ausgebildet ist, der dem ersten leitfähigen Element (14) zugewandt ist.

10. Sensor (10, 10', 10") nach Anspruch 9, der eine Vielzahl von Verbindungselementen (24, 24a - 24d) umfasst, wobei ein jedes der Verbindungselemente (24, 24a - 24d), ein auf dem Substrat (12) ausgebildetes elektrisch leitfähiges Pad-Element (26) umfasst und weiterhin eine auf dem Pad-Element (26) ausgebildete Lötschicht (28) umfasst und das Pad-Element (26) mit dem Kappenelement (30) verbindet.

11. Sensor (10, 10', 10") nach Anspruch 10, wobei die Verbindungselemente (24, 24a-24d) konzentrisch bezüglich des ersten leitfähigen Elements (14) und/oder des Kappenelements (30) und/oder des zweiten leitfähigen Elements angeordnet sind.

12. Sensor (10, 10', 10") nach einem der Ansprüche 9 bis 11, wobei der ausgesparte Abschnitt (32) kreisförmig ist.

13. Sensor (10, 10', 10") nach Anspruch 12, wobei eine untere Oberflächenseite des Kappenelements (30) einen Verbindungsbereich (34) umfasst, wobei der Verbindungsbereich (34) bezüglich des ausgesparten Abschnitts (32) erhöht ist und wenigstens teilweise den ausgesparten Abschnitt (32) umgibt, wobei die Abstandselemente (18, 18a - 18h) den Verbindungsbereich (34) halten und/oder das Verbindungselement (24, 24a - 24d) mit dem Verbindungsbereich (34) verbunden ist.

14. Sensor (10, 10', 10") nach einem der Ansprüche 9 bis 13, der weiterhin ein auf dem Kappenelement (30) an einer Seite gegenüber dem zweiten leitfähigen Element ausgebildetes Kraftkonzentrations-Pad (40, 40', 40") umfasst, vorzugsweise mittig auf dem zweiten leitfähigen Element angeordnet.

15. Sensor (10, 10', 10") nach einem der Ansprüche 9 bis 14, der weiterhin ein Kraftverteilungselement (44) auf dem Kappenelement (30) umfasst, vorzugsweise am Umfang entlang einer Begrenzung des Kappenelements (30).

**Revendications**

1. Procédé de fabrication d'un capteur de force capacitif (10, 10', 10"), comprenant :

prévoir un premier élément conducteur (14) sur un substrat (12), plusieurs éléments d'espacement (18, 18a-18h) et un élément de plot électriquement conducteur (26) étant formés sur le substrat (12) ;
prévoir une brasure chauffée (28) sur l'élément de plot (26) ;
prévoir un élément capuchon (30), l'élément capuchon (30) comprenant un deuxième élément conducteur ;
placer l'élément capuchon (30) sur les éléments d'espacement (18, 18a-18h) ;
relier l'élément capuchon (30) à l'élément de plot (26) par l'intermédiaire de la brasure (28) de sorte que le deuxième élément conducteur soit tourné vers le premier élément conducteur (14) et écarté du premier élément conducteur (14) ; et
permettre à la brasure (28) de se solidifier ;
**caractérisé par** la réalisation d'un tronçon évidé (32) d'un côté de surface inférieure de l'élément capuchon (30), lequel est tourné vers le premier élément conducteur (14).

**2.** Procédé selon la revendication 1, plusieurs éléments de plot électriquement conducteurs (26) étant réalisés sur le substrat (12), et le procédé comprenant les étapes dans lesquelles une brasure (28) est prévue sur chacun des plusieurs éléments de plot (26) et l'élément capuchon (30) est relié aux plusieurs éléments de plot (26) par l'intermédiaire de la brasure (28).

**3.** Procédé selon la revendication 2, les éléments de plot (26) étant positionnés de manière concentrique par rapport au premier élément conducteur (14) et/ou à l'élément capuchon (30) et/ou au deuxième élément conducteur.

**4.** Procédé selon la revendication 2 ou 3, les éléments de plot (26) étant positionnés sur le substrat (12) par rapport au premier élément conducteur (14) de telle sorte que le deuxième élément conducteur s'aligne lui-même sur le premier élément conducteur (14) par des forces capillaires entre la brasure (28) et l'élément capuchon (30) lorsque l'élément capuchon (30) est placé sur la brasure (28).

**5.** Procédé selon l'une des revendications 2 à 4, l'élément capuchon (30) étant relié aux plusieurs éléments de plot (26) et à la brasure (28) de telle sorte que chaque élément de plot (26) et la brasure (28) ne soient que partiellement recouverts par l'élément capuchon (30).

**6.** Procédé selon l'une des revendications précédentes, comprenant une étape dans laquelle une couche de recouvrement (16; 22) est prévue sur le premier élément conducteur (14) et/ou sur le deuxième élément conducteur et/ou sur les éléments d'espacement (18, 18a-18h), la couche de recouvrement (16; 22) comprenant de préférence un vernis de protection contre la brasure.

**7.** Procédé selon l'une des revendications précédentes, dans lequel il est en outre prévu un plot de concentration de force (40, 40', 40") sur l'élément capuchon (30) d'un côté opposé au deuxième élément conducteur, de préférence centré sur le deuxième élément conducteur.

**8.** Procédé selon l'une des revendications précédentes, dans lequel il est en outre prévu une couche superficielle (52) superposée sur l'élément capuchon (30), la couche superficielle (52) comprenant de préférence un plot de concentration de force (40, 40', 40") et/ou un élément de distribution de force (44).

**9.** Capteur de force capacitif (10, 10', 10"), comprenant :

un substrat (12) ;
un premier élément conducteur (14) réalisé sur le substrat (12) ;
plusieurs éléments d'espacement (18, 18a-18h) réalisés sur le substrat (12) ;
un élément capuchon (30) soutenu par les éléments d'espacement (18, 18a-18h), l'élément capuchon (30) comprenant un deuxième élément conducteur qui est tourné vers le premier élément conducteur (14) et qui est espacé du premier élément conducteur (14) ; et
au moins un élément de connexion (24, 24a-24d), l'élément de connexion (24, 24a-24d) comprenant un élément de plot électriquement conducteur (26) qui est réalisé sur le substrat (12) et comprenant en outre une couche de brasure (28) qui est réalisée sur l'élément de plot (26) et relie l'élément de plot (26) à l'élément capuchon (30) ;
**caractérisé en ce qu'**un côté de surface inférieure de l'élément capuchon (30) comprend un tronçon évidé (32) qui est tourné vers le premier élément conducteur (14).

**10.** Capteur (10, 10', 10") selon la revendication 9, comprenant plusieurs éléments de connexion (24, 24a-24d), chaque élément de connexion (24, 24a-24d) comprenant un élément de plot électriquement conducteur (26) qui est réalisé sur le substrat (12) et comprenant en outre une couche de brasure (28) qui est réalisée sur l'élément de plot (26) et relie l'élément de plot (26) à l'élément capuchon (30).

**11.** Capteur (10, 10', 10") selon la revendication 10, les éléments de connexion (24, 24a-24d) étant positionnés de manière concentrique par rapport au premier élément conducteur (14) et/ou à l'élément capuchon (30) et/ou au deuxième élément conducteur.

**12.** Capteur (10, 10', 10") selon l'une des revendications 9 à 11, le tronçon évidé (32) étant circulaire.

**13.** Capteur (10, 10', 10") selon la revendication 12, un côté de surface inférieure de l'élément capuchon (30) comprenant un tronçon de connexion (34), le tronçon de connexion (34) étant élevé par rapport au tronçon évidé (32) et entourant le tronçon évidé (32) au moins partiellement, les éléments d'espacement (18, 18a-18h) soutenant le tronçon de connexion (34) et/ou l'élément de connexion (24, 24a-24d) étant relié au tronçon de connexion (34).

**14.** Capteur (10, 10', 10") selon l'une des revendications 9 à 13, comprenant en outre un plot de concentration de force (40, 40', 40") qui est réalisé sur l'élément capuchon (30) d'un côté opposé au deuxième élément conducteur, de préférence centré sur le deuxième élément conducteur.

**15.** Capteur (10, 10', 10") selon l'une des revendications 9 à 14, comprenant en outre un élément de distribution de force (44) sur l'élément capuchon (30), de préférence circonférentiellement le long d'une délimitation de l'élément capuchon (30).

equivalent capacitors

GND

$C_{plate}$

signal

$C_{bulk}$

GND

$r_{plate}$

$r_{pad}$

$r_{Con}$

F

34   30   $40$

$34$

$t_{plate}$

$28$   $22$  $18$   $16$   $32$  $\varepsilon_{Air}$   $18$  $22$  $28$   $d_0$

$\varepsilon_{24}$   $t_{cov}$

$20$  $14$   $20$   $26$   $t_{Cu}$

$26$   $12$

$\varepsilon_{FR4}$   $t_{FR4}$

$t_{Cu}$

$42$

Fig. 1

Fig. 2

Fig. 3a

Fig. 3b

16

*Fig. 4 a*

*Fig. 4 b*

Fig. 5

Fig. 6

Fig 7 a

Fig. 7 b

Fig. 8a

Fig. 8b

EP 2 677 291 B1

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100102830 A1
- US 20030234769 A1
- US 20040227736 A1
- US 20090140410 A1
- JP H03239940 A
- US 2010090297 A1
- US 20080218299 A1